# EUROPÄISCHE PATENTANMELDUNG

(11) **EP 3 480 932 A1**
(43) Veröffentlichungstag der Anmeldung: **08.05.2019**
(21) Anmeldenummer: 18199027.6
(22) Anmeldetag: 08.10.2018
(51) Int. Cl.: H02M 1/32, H02M 7/483, H02M 1/06

(54) **ELEKTRISCHE ANORDNUNG MIT TEILMODULEN SOWIE TEILMODULE ALS SOLCHE**

(30) Priorität: 02.11.2017 DE 102017219499
(71) Anmelder: Siemens Aktiengesellschaft, 80333 München (DE)
(72) Erfinder: Dorn, Jörg, 96155 Buttenheim (DE); Hacker, Felix, 90419 Nürnberg (DE); Schmitt, Daniel, 92353 Postbauer-Heng (DE); Schremmer, Frank, 90768 Fürth (DE); Wahle, Marcus, 90587 Veitsbronn (DE)

(57) **Zusammenfassung**

Die Erfindung bezieht sich auf eine elektrische Anordnung (10) mit zumindest einem Teilmodul (TM), das einen ersten und einen zweiten äußeren elektrischen Anschluss (TM1, TM2) aufweist.

Erfindungsgemäß ist vorgesehen, dass die Anordnung (10) zumindest eine Bypassschalteinrichtung (BPS) aufweist, die elektrisch zwischen den ersten und zweiten Anschluss (TM1, TM2) des Teilmoduls (TM) geschaltet ist und im eingeschalteten Zustand einen elektrischen Kurzschluss in zumindest einer Stromflussrichtung zwischen den beiden äußeren Anschlüssen (TM1, TM2) des Teilmoduls (TM) hervorruft, wobei die Bypassschalteinrichtung (BPS) aufweist: einen Thyristor (T1, T2), der einen Anodenanschluss (A), einen Kathodenanschluss (K) und einen Zündanschluss (Z) aufweist, mit seinem Anodenanschluss (A) an einen der beiden äußeren Anschlüsse (TM1, TM2) des Teilmoduls (TM) angeschlossen ist und mit seinem Kathodenanschluss (K) an den anderen der beiden äußeren Anschlüsse (TM1, TM2) des Teilmoduls (TM) angeschlossen ist, eine an den Zündanschluss (Z) des Thyristors (T1, T2) angeschlossene Zündeinrichtung (22, 22a) zum Zünden des Thyristors (T1, T2) und einen Schalter (S1, S2), der im eingeschalteten Zustand den Anodenanschluss (A) des Thyristors (T1, T2) mit dem Zündanschluss (Z) des Thyristors (T1, T2) verbindet.

## Beschreibung

Die Erfindung bezieht sich auf eine elektrische Anordnung mit zumindest einem Teilmodul, das einen ersten und einen zweiten äußeren elektrischen Anschluss aufweist. Derartige Anordnungen sind beispielsweise aus dem Bereich der Umrichtertechnik, insbesondere dem Bereich der modularen Multilevelumrichter, bekannt.

Ein modularer Multilevelumrichter ist beispielsweise in der Druckschrift "Modular Multilevel Converter: An universal concept for HVDC-Networks and extended DC-Bus-Applications" (R. Marquardt, 2010 International Power Electronics Conference, Seiten 502 bis 507, 978-1-4244-5393-1/10, 2010 IEEE) beschrieben. In der Druckschrift sind Teilmodule offenbart, die Halb- und Vollbrücken umfassen.

Der Erfindung liegt die Aufgabe zugrunde, eine elektrische Anordnung mit zumindest einem Teilmodul anzugeben, bei dem ein schnelles Kurzschließen der äußeren Anschlüsse des Teilmoduls - in zumindest einer Stromrichtung - in einfacher Weise erreicht werden kann.

Diese Aufgabe wird erfindungsgemäß durch eine Anordnung mit den Merkmalen gemäß Patentanspruch 1 gelöst. Vorteilhafte Ausgestaltungen der erfindungsgemäßen Anordnung sind in Unteransprüchen angegeben.

Danach ist erfindungsgemäß vorgesehen, dass die Anordnung zumindest eine Bypassschalteinrichtung aufweist, die elektrisch zwischen den ersten und zweiten Anschluss des Teilmoduls geschaltet ist und im eingeschalteten Zustand einen elektrischen Kurzschluss in zumindest einer Stromflussrichtung zwischen den beiden äußeren Anschlüssen des Teilmoduls hervorruft, wobei die Bypassschalteinrichtung aufweist:
- einen Thyristor, der einen Anodenanschluss, einen Kathodenanschluss und einen Zündanschluss aufweist, mit seinem Anodenanschluss an einen der beiden äußeren Anschlüsse des Teilmoduls angeschlossen ist und mit seinem Kathodenanschluss an den anderen der beiden äußeren Anschlüsse des Teilmoduls angeschlossen ist,
- eine an den Zündanschluss des Thyristors angeschlossene Zündeinrichtung zum Zünden des Thyristors und
- einen Schalter, der im eingeschalteten Zustand den Anodenanschluss des Thyristors mit dem Zündanschluss des Thyristors verbindet.

Ein wesentlicher Vorteil der erfindungsgemäßen Anordnung ist darin zu sehen, dass durch die erfindungsgemäß vorgesehene Bypassschalteinrichtung, die auf einem durchschaltbaren Thyristor beruht, ein sehr schnelles Hervorrufen eines Kurzschlusses (in Stromflussrichtung des durchgeschalteten Thyristors gesehen) zwischen den beiden Anschlüssen des Teilmoduls auch ohne Einsatz pyrotechnischen Materials möglich ist. Die hohe Schaltgeschwindigkeit (von ca. 10 µs) kann erreicht werden, weil der Thyristor zweistufig eingeschaltet werden kann: In der ersten Phase beruht das Einschalten auf der Zündeinrichtung, die bei Vorliegen eines Bypassaktivierungssignals aktiv ein Zünden des Thyristors hervorruft. Der Schalter zwischen dem Anodenanschluss des Thyristors und dem Zündanschluss kann während des aktiven Zündens des Thyristors - vergleichsweise langsam mit einer Schaltgeschwindigkeit im einstelligen Millisekundenbereich - eingeschaltet werden, so dass ein zweiter Zündpfad zum dauerhaften Zünden des Thyristors aktiviert wird, der auch nach einem Abschalten der Zündeinrichtung - also in einer zweiten Phase - den Thyristor im eingeschalteten Zustand belässt. Die erfindungsgemäße Bypassschalteinrichtung ist also wegen des aktiven Zündens des Thyristors schnell und wird durch den Schalter, der vergleichsweise langsam arbeiten kann, in einen dauerhaften Diodenbetrieb geschaltet.

Vorteilhaft ist es, wenn die elektrische Anordnung eine Steuereinrichtung aufweist, die beim Vorliegen eines Bypassaktivierungssignals die Zündeinrichtung mit einem Zündsignal aktiviert und den Schalter schließt.

Die Steuereinrichtung ist bevorzugt derart ausgestaltet, dass sie das Zündsignal zum Aktivieren der Zündeinrichtung und zum Zünden des Thyristors mindestens solange an den Zündanschluss anlegt, bis der Schalter seinen eingeschalteten Zustand erreicht hat.

Die Zündeinrichtung ist elektrisch vorzugsweise zwischen den Zündanschluss und den Kathodenanschluss des Thyristors geschaltet.

Bezüglich des Teilmoduls wird es als vorteilhaft angesehen, insbesondere mit Blick auf einen Einsatz in einem Umrichter wie beispielsweise einem Multilevelumrichter, wenn das Teilmodul zwischen dem ersten und dem zweiten Anschluss ein Schaltelement, insbesondere einen Transistor, und eine dazu parallel geschaltete Freilaufdiode aufweist, deren Kathodenanschluss an den ersten Anschluss des Teilmoduls und deren Anodenanschluss an den zweiten Anschluss des Teilmoduls angeschlossen ist.

Bezüglich der Verschaltung der Komponenten wird es als vorteilhaft angesehen, wenn der Anodenanschluss des Thyristors an den ersten Anschluss des Teilmoduls angeschlossen ist, der Kathodenanschluss des Thyristors an den zweiten Anschluss des Teilmoduls angeschlossen ist, der Schalter im eingeschalteten Zustand den Anodenanschluss des Thyristors und damit den ersten Anschluss des Teilmoduls mit dem Zündanschluss des Thyristors verbindet und die Zündeinrichtung elektrisch zwischen den Zündanschluss des Thyristors und den zweiten Anschluss des Teilmoduls geschaltet ist.

Um einen Kurzschlussstrom bidirektional an dem Teilmodul vorbeileiten zu können, wird es als vorteilhaft angesehen, wenn die Bypassschalteinrichtung zusätzlich zu dem erwähnten Thyristor, nachfolgend erster Thyristor genannt, einen weiteren Thyristor, nachfolgend zweiter Thyristor genannt, sowie zusätzlich zu dem erwähnten Schalter, nachfolgend erster Schalter genannt, einen weiteren Schalter, nachfolgend zweiter Schalter genannt, aufweist, der zweite Thyristor mit seinem Anodenanschluss an den zweiten Anschluss des Teilmoduls und mit seinem Kathodenanschluss an den ersten Anschluss des Teilmoduls angeschlossen ist, und der zweite Schalter im eingeschalteten Zustand den Anodenanschluss des zweiten Thyristors und damit den zweiten Anschluss des Teilmoduls mit dem Zündanschluss des zweiten Thyristors verbindet.

Bei der letztgenannten Variante ist es außerdem vorteilhaft, wenn die Bypassschalteinrichtung zusätzlich zu der erwähnten Zündeinrichtung, nachfolgend erste Zündeinrichtung genannt, eine weitere Zündeinrichtung, nachfolgend zweite Zündeinrichtung genannt, aufweist, die erste Zündeinrichtung elektrisch zwischen den Zündanschluss des ersten Thyristors und den zweiten Anschluss des Teilmoduls geschaltet ist und die zweite Zündeinrichtung elektrisch zwischen den Zündanschluss des zweiten Thyristors und den ersten Anschluss des Teilmoduls geschaltet ist.

Das Teilmodul ist vorzugsweise ein Halbbrückenmodul oder ein Vollbrückenmodul oder wird vorzugsweise durch eine Reihenschaltung aus Halbbrückenmodulen und/oder Vollbrückenmodulen gebildet.

Mit Blick auf einen Einsatz der Anordnung in einem Umrichter, beispielsweise einem Multilevelumrichter, oder einem Blindleistungssteller wird es als vorteilhaft angesehen, wenn die Anordnung zwei oder mehr Teilmodule aufweist, die unter Bildung einer Teilmodulreihenschaltung elektrisch in Reihe geschaltet sind und jeweils einen ersten und zweiten äußeren elektrischen Anschluss umfassen, wobei die elektrisch innenliegenden Teilmodule der Teilmodulreihenschaltung mit ihrem ersten Anschluss an einen zweiten Anschluss eines potentialmäßig höher liegenden Teilmoduls der Teilmodulreihenschaltung und mit ihrem zweiten Anschluss an einen ersten Anschluss eines potentialmäßig tiefer liegenden Teilmoduls der Teilmodulreihenschaltung angeschlossen sind.

Jedes Teilmodul ist bevorzugt jeweils mit einer eigenen Bypassschalteinrichtung versehen.

Vorteilhaft ist es, wenn - wie erwähnt - die elektrische Anordnung einen modularen Multilevelumrichter mit zumindest einer Teilmodulreihenschaltung bildet, die mindestens zwei in Reihe geschaltete Teilmodule und eine Induktivität umfasst.

Die Erfindung bezieht sich darüber hinaus auf ein Teilmodul mit einem ersten und einem zweiten äußeren elektrischen Anschluss für eine elektrische Anordnung, wie sie oben beschrieben worden ist, also insbesondere für einen Umrichter, Multilevelumrichter oder Blindleistungssteller.

Erfindungsgemäß ist bezüglich eines solchen Teilmoduls vorgesehen, dass das Teilmodul zumindest eine Bypassschalteinrichtung aufweist, die elektrisch zwischen den ersten und zweiten Anschluss des Teilmoduls geschaltet ist und im eingeschalteten Zustand einen elektrischen Kurzschluss zwischen den beiden äußeren Anschlüssen des Teilmoduls hervorruft, wobei die Bypassschalteinrichtung aufweist:
- einen Thyristor, der einen Anodenanschluss, einen Kathodenanschluss und einen Zündanschluss aufweist, mit seinem Anodenanschluss an einen der beiden äußeren Anschlüsse des Teilmoduls angeschlossen ist und mit seinem Kathodenanschluss an den anderen der beiden äußeren Anschlüsse des Teilmoduls angeschlossen ist,
- eine an den Zündanschluss des Thyristors angeschlossene Zündeinrichtung zum Zünden des Thyristors und
- einen Schalter, der im eingeschalteten Zustand den Anodenanschluss des Thyristors und mit dem Zündanschluss des Thyristors verbindet.

Bezüglich der Vorteile des erfindungsgemäßen Teilmoduls sei auf die obigen Ausführungen im Zusammenhang mit der erfindungsgemäßen Anordnung verwiesen.

Zwischen den ersten und zweiten Anschluss des Teilmoduls sind vorzugsweise geschaltet:
- ein erstes Schaltelement, insbesondere ein erster Transistor,
- eine zu dem ersten Schaltelement parallel geschaltete Freilaufdiode, deren Kathodenanschluss an den ersten Anschluss des Teilmoduls und deren Anodenanschluss an den zweiten Anschluss des Teilmoduls angeschlossen ist, und
- eine Reihenschaltung aus einem zweiten Schaltelement, zu dem eine zweite Freilaufdiode parallel geschaltet ist, und ein Energiespeicher, insbesondere Kondensator.

Auch ist es vorteilhaft, wenn die Bypassschalteinrichtung zusätzlich zu dem erwähnten Thyristor, nachfolgend erster Thyristor genannt, einen weiteren Thyristor, nachfolgend zweiter Thyristor genannt, zusätzlich zu dem erwähnten Schalter, nachfolgend erster Schalter genannt, einen weiteren Schalter, nachfolgend zweiter Schalter genannt, sowie zusätzlich zu der erwähnten Zündeinrichtung, nachfolgend erste Zündeinrichtung genannt, eine weitere Zündeinrichtung, nachfolgend zweite Zündeinrichtung genannt, aufweist, der erste Thyristor mit seinem Anodenanschluss an den ersten Anschluss des Teilmoduls und mit seinem Kathodenanschluss an den zweiten Anschluss des Teilmoduls angeschlossen ist, der erste Schalter im eingeschalteten Zustand den Anodenanschluss des ersten Thyristors und damit den ersten Anschluss des Teilmoduls mit dem Zündanschluss des ersten Thyristors verbindet, der zweite Thyristor mit seinem Anodenanschluss an den zweiten Anschluss des Teilmoduls und mit seinem Kathodenanschluss an den ersten Anschluss des Teilmoduls angeschlossen ist, der zweite Schalter im eingeschalteten Zustand den Anodenanschluss des zweiten Thyristors und damit den zweiten Anschluss des Teilmoduls mit dem Zündanschluss des zweiten Thyristors verbindet, die erste Zündeinrichtung elektrisch zwischen den Zündanschluss des ersten Thyristors und den zweiten Anschluss des Teilmoduls geschaltet ist, die zweite Zündeinrichtung elektrisch zwischen den Zündanschluss des zweiten Thyristors und den ersten Anschluss des Teilmoduls geschaltet ist, die elektrische Anordnung eine oder mehr Steuereinrichtungen aufweist, die beim Vorliegen eines Bypassaktivierungssignals die erste und zweite Zündeinrichtung mit einem Zündsignal aktivieren und den ersten und zweiten Schalter schließen und die Steuereinrichtung oder Steuereinrichtungen derart ausgestaltet sind, dass sie die Zündsignale zum Zünden der Thyristoren mindestens solange an den Zündanschluss anlegt, bis der erste und zweite Schalter ihren eingeschalteten Zustand erreicht haben.

Die Erfindung wird nachfolgend anhand von Ausführungsbeispielen näher erläutert; dabei zeigen beispielhaft
- Figur 1: ein Ausführungsbeispiel für eine Anordnung mit einem Teilmodul und einer dazu parallel geschalteten Bypassschalteinrichtung, die unidirektional arbeitet und unidirektional einen Kurzschluss bilden kann,
- Figur 2: ein Ausführungsbeispiel für ein erfindungsgemäßes Teilmodul, bei dem die in der Figur 1 gezeigte Bypassschalteinrichtung einen teilmoduleigenen Bestandteil des Teilmoduls bildet,
- Figur 3: ein Ausführungsbeispiel für eine Anordnung mit einem Teilmodul und einer dazu parallel geschalteten Bypassschalteinrichtung, die bidirektional arbeitet und bidirektional einen elektrischen Kurzschluss bilden kann,
- Figur 4: ein Ausführungsbeispiel für ein erfindungsgemäßes Teilmodul, bei dem die in der Figur 3 gezeigte bidirektional arbeitende Bypassschalteinrichtung einen teilmoduleigenen Bestandteil des Teilmoduls bildet,
- Figur 5: ein Ausführungsbeispiel für eine Anordnung mit einem Teilmodul und einer dazu parallel geschalteten Bypassschalteinrichtung, die wie bei den Ausführungsbeispielen gemäß den Figuren 1 und 2 unidirektional arbeitet, jedoch mit entgegengesetzter Polarität,
- Figur 6: ein Ausführungsbeispiel für ein Teilmodul, das die in der Figur 5 gezeigte Bypassschalteinrichtung als teilmoduleigenen Bestandteil aufweist, und
- Figur 7: ein Ausführungsbeispiel für einen modularen Multilevelumrichter, der Teilmodule, wie sie unten beispielhaft im Zusammenhang mit den Figuren 1 bis 6 gezeigt und erläutert werden, aufweist.

In den Figuren werden der Übersicht halber für identische oder vergleichbare Komponenten stets dieselben Bezugszeichen verwendet.

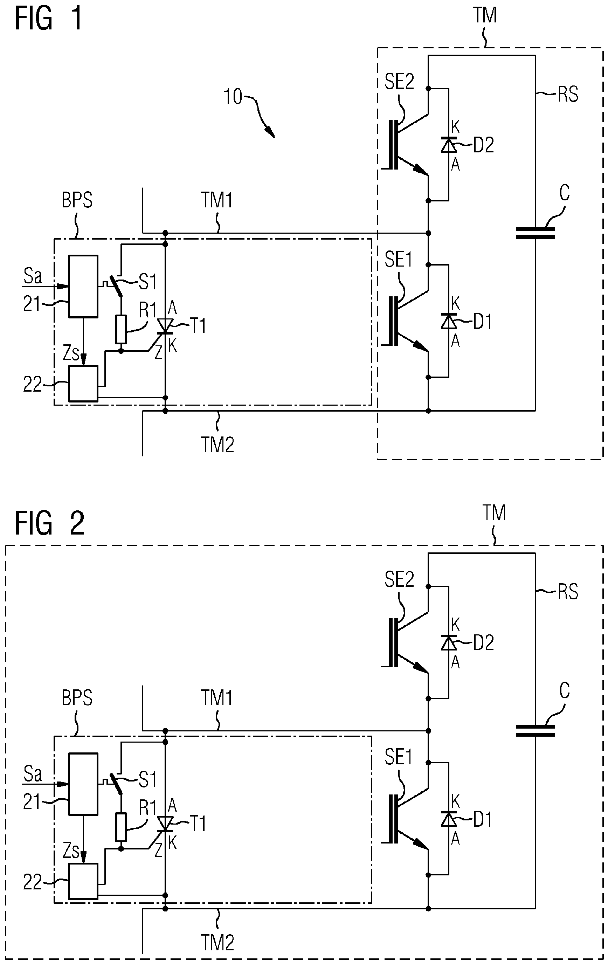

Die Figur 1 zeigt ein Ausführungsbeispiel für eine elektrische Anordnung 10, die ein Teilmodul TM aufweist.

Das Teilmodul TM umfasst ein erstes Schaltelement SE1, insbesondere in Form eines Transistors, das elektrisch zwischen einen ersten Anschluss TM1 und einen zweiten Anschluss TM2 des Teilmoduls TM geschaltet ist. Parallel zu dem ersten Schaltelement SE1 liegt eine erste Freilaufdiode D1, deren Kathodenanschluss K an den ersten Anschluss TM1 des Teilmoduls TM und deren Anodenanschluss A an den zweiten Anschluss TM2 des Teilmoduls TM angeschlossen ist.

Zwischen den beiden Anschlüssen TM1 und TM2 des Teilmoduls TM ist darüber hinaus eine Reihenschaltung RS geschaltet, die ein zweites Schaltelement SE2, insbesondere in Form eines zweiten Transistors, sowie eine dazu parallel geschaltete zweite Freilaufdiode D2 und einen Energiespeicher in Form eines Kondensators C umfasst. Der Anodenanschluss A der zweiten Freilaufdiode D2 ist an den ersten Anschluss TM1 des Teilmoduls TM angeschlossen; der Kathodenanschluss K der zweiten Freilaufdiode D2 steht mit dem Kondensator C in Verbindung.

Die beschriebenen Komponenten des Teilmoduls TM bilden elektrisch ein Halbbrückenmodul. Alternativ kann das Teilmodul TM auch elektrisch ein Vollbrückenmodul bilden oder aus einer Reihenschaltung aus Halbbrückenmodulen, wie in Figur 1 gezeigt, und/oder Vollbrückenmodulen gebildet sein.

Elektrisch zwischen den ersten Anschluss TM1 und den zweiten Anschluss TM2 des Teilmoduls TM ist eine Bypassschalteinrichtung BPS geschaltet, die unidirektional arbeitet und im eingeschalteten Zustand einen elektrischen Kurzschluss zwischen den beiden Anschlüssen TM1 und TM2 in der Stromflussrichtung vom ersten Anschluss TM1 zum zweiten Anschluss TM2 hervorrufen kann.

Die Bypassschalteinrichtung BPS weist einen Thyristor T1 auf, dessen Anodenanschluss A an den ersten Anschluss TM1 des Teilmoduls TM und dessen Kathodenanschluss K an den zweiten Anschluss TM2 des Teilmoduls TM angeschlossen ist. Der Zündanschluss Z des Thyristors T1 steht über einen Widerstand R1 und einen elektrischen Schalter S1 mit dem ersten Anschluss TM1 des Teilmoduls TM und damit mit dem Anodenanschluss A des Thyristors T1 in Verbindung.

Die Ansteuerung des Schalters S1 bzw. das Öffnen und Schließen des Schalters S1 erfolgt durch eine Steuereinrichtung 21, die eingangsseitig mit einem Bypassaktivierungssignal Sa beaufschlagt werden kann.

Die Steuereinrichtung 21 steht darüber hinaus mit einer Zündeinrichtung 22 in Verbindung, die mit dem Zündanschluss Z des Thyristors T1 sowie mit dem Kathodenanschluss des Thyristors T1 und damit mit dem zweiten Anschluss TM2 des Teilmoduls TM verbunden ist.

Die Anordnung 10 bzw. die Bypassschalteinrichtung BPS kann wie folgt betrieben werden:
Soll im Falle eines Fehlers der Anordnung 10, insbesondere auch im Falle eines Fehlers des Teilmoduls TM, ein Kurzschluss zwischen dem ersten Anschluss TM1 und dem zweiten Anschluss TM2 für einen Stromfluss vom ersten Anschluss TM1 in Richtung des zweiten Anschlusses T2 erzeugt werden, so wird an die Steuereinrichtung 21 das Bypassaktivierungssignal Sa angelegt. Bei Vorliegen des Bypassaktivierungssignals Sa aktiviert die Steuereinrichtung 21 die Zündeinrichtung 22, die daraufhin einen Zündstrom zum Zünden des Thyristors T1 in den Zündanschluss Z einspeist. Geeignete Zündeinrichtungen 22 zum Zünden des Thyristors T1 können beispielsweise der Schrift "Technical Information, Bipolar Semiconductors" (Infineon Technologies Bipolar GmbH & Co. KG, Max-Planck-Str. 5, 59581 Warstein; Order Number: B157-H9716-X-X-7600, April 2012) entnommen werden.

Darüber hinaus erzeugt die Steuereinrichtung 21 ein Schaltsignal zum Einschalten des Schalters S1. Die Steuereinrichtung 21 ist dabei derart ausgebildet, dass sie das Zündsignal Zs zum Aktivieren der Zündeinrichtung 22 und damit zum Zünden des Thyristors T1 zumindest solange erzeugt, dass der Thyristor T1 solange mit einem Zündstrom versorgt wird und gezündet bleibt, bis der Schalter S1 seinen eingeschalteten Zustand erreicht hat. Durch diese Maßnahmen ist sichergestellt, dass der Thyristor T1 nach Eingang des Bypassaktivierungssignals Sa zumindest solange durch die Zündeinrichtung 22 gezündet wird und damit eingeschaltet bleibt, bis der Schalter S1 geschlossen ist und somit der durch den Schalter S1 und den Widerstand R1 gebildete Ersatzpfad zum Zünden des Thyristors T1 aktiviert wird.

Mit anderen Worten dient die Reihenschaltung aus dem Schalter S1 und dem Widerstand R1 zwischen dem Zündanschluss Z des Thyristors T1 und dem Anodenanschluss A des Thyristors T1 dazu, eine Ersatzzündeinrichtung zu bilden, die nach dem Einschalten des Schalters S1 dauerhaft ein Zünden des Thyristors T1 bewirkt und damit dauerhaft den eingeschalteten Zustand des Thyristors T1 sicherstellt. Mit dem Einschalten des Schalters S1 wird der Thyristor T1 elektrisch zu einer Diode, die in Stromrichtung von der Anode A zur Kathode K stets Strom führen kann.

Die Figur 2 zeigt ein Ausführungsbeispiel für ein Teilmodul TM, das das im Zusammenhang mit der Figur 1 beschriebene Halbbrückenmodul, gebildet durch die beiden Schaltelemente SE1 und SE2, die beiden Freilaufdioden D1 und D2 und den Kondensator C, sowie darüber hinaus die Bypassschalteinrichtung BPS gemäß Figur 1 umfasst. Im Unterschied zu dem Ausführungsbeispiel gemäß Figur 1 ist die Bypassschalteinrichtung BPS somit ein Bestandteil des Teilmoduls TM. Im Übrigen gelten die obigen Ausführungen im Zusammenhang mit der Figur 1 entsprechend.

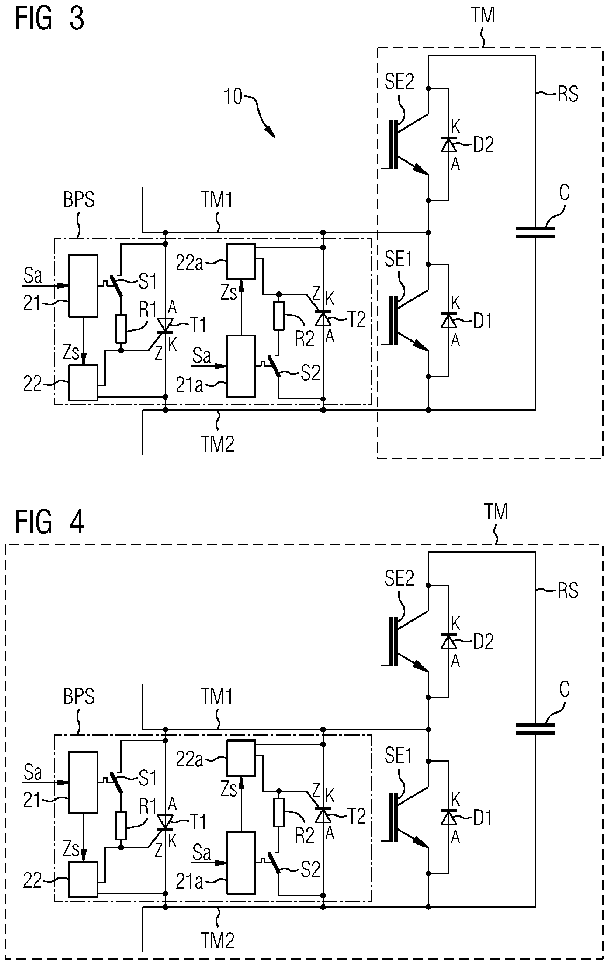

Die Figur 3 zeigt ein Ausführungsbeispiel für eine elektrische Anordnung 10, die das bereits im Zusammenhang mit der Figur 1 beschriebene Teilmodul TM sowie eine zwischen den beiden Anschlüssen TM1 und TM2 des Teilmoduls TM geschaltete Bypassschalteinrichtung BPS aufweist.

Die Bypassschalteinrichtung BPS gemäß Figur 3 umfasst auf der linken Bildseite in Figur 3 die im Zusammenhang mit der Figur 1 beschriebenen Komponenten, also die Steuereinrichtung 21, die Zündeinrichtung 22, den Schalter S1, den Widerstand R1 sowie den Thyristor T1. Diese Komponenten dienen dazu, bei Anlegen des Bypassaktivierungssignals Sa den Thyristor T1 einzuschalten, um einen Kurzschluss für die Stromrichtung vom ersten Anschluss TM1 zum zweiten Anschluss TM2 des Teilmoduls TM zu bewirken.

Um auch einen Kurzschlussstrom vom zweiten Anschluss TM2 in Richtung des ersten Anschlusses T1 an dem Teilmodul TM vorbeileiten zu können, beispielsweise um die Freilaufdiode D1 elektrisch zu entlasten bzw. eine Überlastung dieser Freilaufdiode D1 zu vermeiden, weist die Bypassschalteinrichtung BPS bei dem Ausführungsbeispiel gemäß Figur 3 zusätzlich einen Kurzschlusspfad für die andere Stromrichtung auf. Dieser Kurzschlusspfad umfasst einen zweiten Thyristor T2, dessen Anodenanschluss A an den zweiten Anschluss TM2 des Teilmoduls TM und damit an den Kathodenanschluss K des Thyristors T1, nachfolgend erster Thyristor genannt, angeschlossen ist. Der Kathodenanschluss K des zweiten Thyristors T2 steht mit dem ersten Anschluss TM1 des Teilmoduls TM und damit mit dem Anodenanschluss A des ersten Thyristors T1 in Verbindung.

Zum Zünden des zweiten Thyristors T2 ist eine zweite Zündeinrichtung 22a vorgesehen, die elektrisch zwischen den Zündanschluss Z des zweiten Thyristors T2 und den ersten Anschluss TM1 des Teilmoduls TM geschaltet ist.

Um nach einem Zünden des zweiten Thyristors T2 dauerhaft den eingeschalteten Zustand des Thyristors T2 gewährleisten zu können, ist zwischen den Zündanschluss Z des zweiten Thyristors T2 und den Anodenanschluss A des zweiten Thyristors T2 ein Ersatzzündpfad geschaltet, der durch eine Reihenschaltung aus einem zweiten Widerstand R2 und einem zweiten Schalter S2 gebildet ist. Die Ansteuerung der zweiten Zündeinrichtung 22a und des zweiten Schalters S2 erfolgt bei dem Ausführungsbeispiel gemäß Figur 3 durch eine zweite Steuereinrichtung 21a.

Die Anordnung 10 gemäß Figur 3 arbeitet vorzugsweise wie folgt:
Bei Anliegen eines Bypassaktivierungssignals Sa an die Steuereinrichtung 21 und die zweite Steuereinrichtung 21a wird die erste Steuereinrichtung 21 den ersten Thyristor T1 durchschalten, wie dies im Zusammenhang mit der Figur 1 bereits erläutert worden ist. Diesbezüglich sei auf die obigen Ausführungen verwiesen.

Die zweite Steuereinrichtung 21a wird in entsprechender Weise die zweite Zündeinrichtung 22a mittels eines Zündsignals Zs zünden, so dass der zweite Thyristor T2 ebenfalls sehr schnell durchgeschaltet wird. Gleichzeitig wird die zweite Steuereinrichtung 21a den zweiten Schalter S2 schließen und somit einen Ersatzzündpfad zum dauerhaften Zünden bzw. für einen dauerhaft eingeschalteten Zustand des zweiten Thyristors T2 aktivieren. Mit anderen Worten arbeiten die zweite Steuereinrichtung 21a und die zweite Zündeinrichtung 22a analog zur ersten Steuereinrichtung 21 und ersten Zündeinrichtung 22, so dass die obigen Ausführungen hier entsprechend gelten.

Bei kurzzeitigen Fehlern ist es vorteilhaft, wenn der zweite Thyristor T2 über die zweite Zündeinrichtung 22a nur temporär angesteuert bzw. durchgeschaltet wird, also wie ein klassischer Thyristor, ohne eine dauerhafte Aktivierung durch den zweiten Schalter S2.

Nach dem Anlegen eines Bypassaktivierungssignals Sa werden die Steuereinrichtungen 21 und 21a über die Zündsignale Zs also die Zündeinrichtungen 22 und 22a aktivieren, so dass durch diese ein Zünden der beiden Thyristoren T1 und T2 ausgelöst wird. Darüber hinaus werden die Schalter S1 und S2 geschlossen, so dass für den nachfolgenden Betrieb selbst nach Abschalten der Zündeinrichtungen 22 und 22a die Thyristoren T1 und T2 eingeschaltet bleiben und jeweils die Funktion einer Diode übernehmen.

Die Bypassschalteinrichtung BPS gemäß Figur 3 arbeitet somit im Unterschied zu den Ausführungsbeispielen gemäß den Figuren 1 und 2 bidirektional, da sie einen Kurzschlussstrom in beiden Stromrichtungen zwischen den beiden Anschlüssen TM1 und TM2 des Teilmoduls TM ermöglicht.

Die Figur 4 zeigt ein Ausführungsbeispiel für ein Teilmodul TM, das das Halbbrückenmodul gemäß Figur 1 sowie zusätzlich die Bypassschalteinrichtung BPS gemäß Figur 3 als teilmoduleigenen Bestandteil aufweist. Das Teilmodul TM gemäß Figur 4 enthält somit eine bidirektionale Bypassschalteinrichtung, die nach einer Aktivierung einen Kurzschlussstrom bidirektional zwischen den beiden Anschlüssen TM1 und TM2 führen kann, wie dies im Zusammenhang mit der Figur 3 oben bereits erläutert worden ist.

Im Zusammenhang mit den Figuren 3 und 4 ist zu erwähnen, dass zum Aktivieren der Zündeinrichtungen 22 und 22a und zum Einschalten der beiden Schalter S1 und S2 nicht - wie in Figuren 3 und 4 gezeigt - zwingend zwei Steuereinrichtungen 21 und 21a vorgesehen sein müssen. Alternativ ist es möglich, mit einer einzigen Steuereinrichtung, beispielsweise der Steuereinrichtung 21, sowohl die Schalter S1 und S2 einzuschalten als auch die Zündsignale Zs zum Aktivieren der beiden Zündeinrichtungen 22 und 22a zur Verfügung zu stellen. Die in den Figuren 3 und 4 gezeigte zweite Steuereinrichtung 21a kann dann eingespart bzw. weggelassen werden.

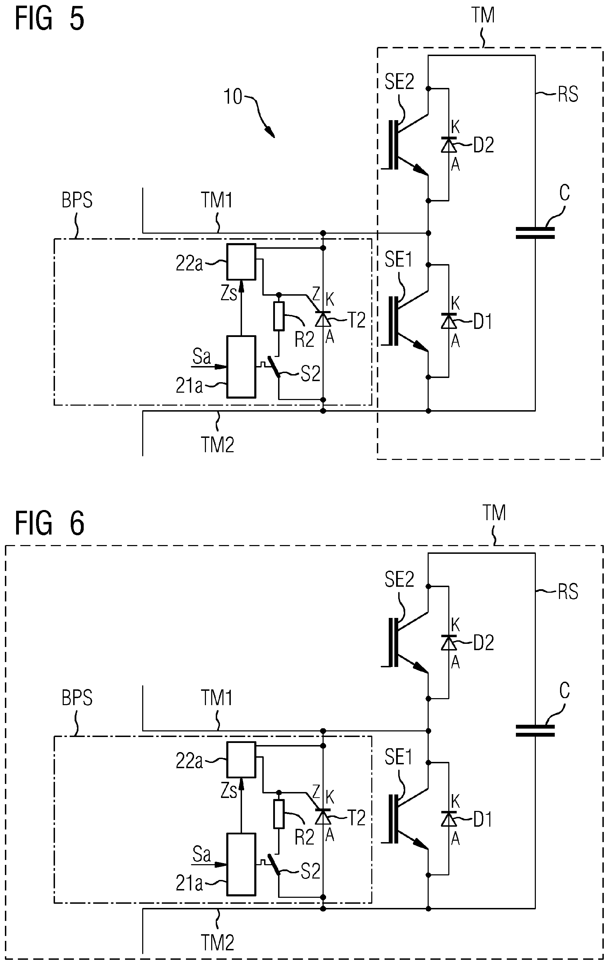

Die Figur 5 zeigt ein Ausführungsbeispiel für eine Anordnung 10, die ein Teilmodul TM in Form eines Halbbrückenmoduls, wie es bereits im Zusammenhang mit der Figur 1 erläutert worden ist, sowie eine dazu parallel geschaltete Bypassschalteinrichtung BPS aufweist.

Die Bypassschalteinrichtung BPS arbeitet bei dem Ausführungsbeispiel gemäß Figur 5 unidirektional und ermöglicht einen Kurzschlussstrom vom zweiten Anschluss TM2 zum ersten Anschluss TM1. Die Bypassschalteinrichtung BPS umfasst zu diesem Zweck im Zusammenhang mit den Figuren 3 und 4 (siehe dort den rechten Bildabschnitt der Bypassschalteinrichtung BPS) oben bereits erläuterte Komponenten, nämlich die zweite Steuereinrichtung 21a, die zweite Zündeinrichtung 22a, den zweiten Thyristor T2, den zweiten Widerstand R2 und den zweiten Schalter S2. Wie bereits im Zusammenhang mit den Figuren 3 und 4 erläutert wurde, sind diese Komponenten in der gezeigten Verschaltung geeignet, nach einem Zünden des zweiten Thyristors T2 einen Kurzschlussstrom an dem Teilmodul TM vorbeizuleiten, und zwar in Stromflussrichtung vom zweiten Anschluss TM2 zum ersten Anschluss TM1 des Teilmoduls TM. Diesbezüglich sei auf die obigen Ausführungen im Zusammenhang mit den Figuren 3 bis 4 verwiesen.

Die Figur 6 zeigt ein Ausführungsbeispiel für ein Teilmodul, das die Bypassschalteinrichtung BPS gemäß Figur 5 als teilmoduleigenen Bestandteil aufweist. Im Übrigen gelten die obigen Ausführungen im Zusammenhang mit der Figur 5 entsprechend.

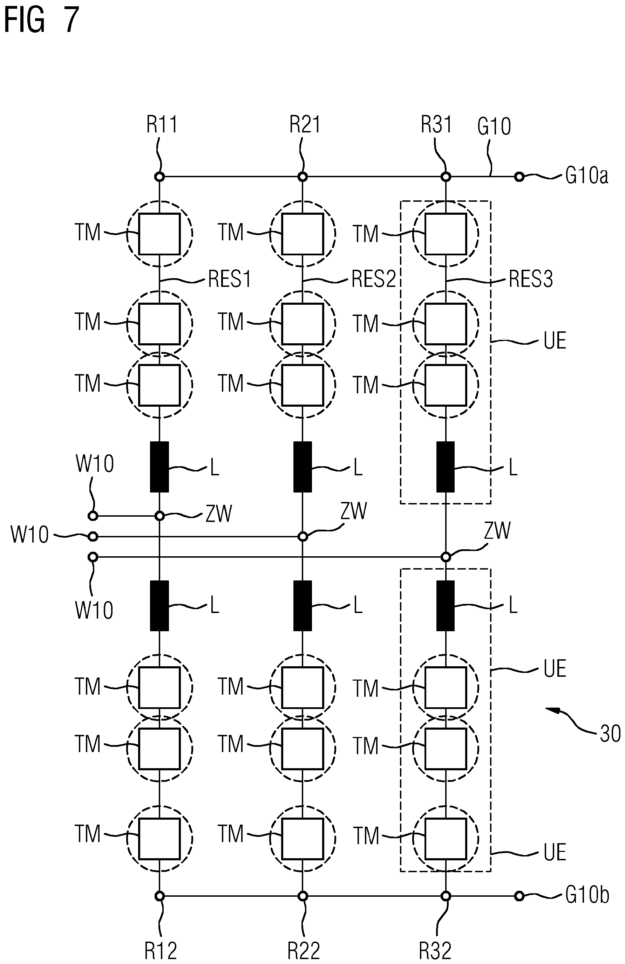

In der Figur 7 ist ein Ausführungsbeispiel für einen dreiphasigen modularen Multilevelumrichter 30 gezeigt. Dieser umfasst Wechselspannungsanschlüsse W10 zum Einspeisen oder zur Entnahme von Wechselstrom. Darüber hinaus ist er mit einer Gleichspannungsseite G10 ausgestattet, die zwei Gleichspannungsanschlüsse G10a und G10b umfasst, über die Gleichstrom eingespeist oder entnommen werden kann.

Der Multilevelumrichter 30 weist drei parallel geschaltete Reihenschaltungen RES1, RES2 und RES3 auf, deren äußere Anschlüsse R11, R21 und R31 mit dem Gleichspannungsanschluss G10a in Verbindung stehen. Die äußeren Anschlüsse R12, R22 und R32 stehen mit dem Gleichspannungsanschluss G10b der Gleichspannungsseite G10 in Verbindung. Mit anderen Worten bilden also die äußeren Anschlüsse der drei Reihenschaltungen RES1, RES2 und RES3 die Gleichspannungsseite G10 des Multilevelumrichters 30.

Jede der drei Reihenschaltungen RES1, RES2 und RES3 ist beispielsweise jeweils mit sechs in Reihe geschalteten Teilmodulen TM sowie zwei Induktivitäten L ausgestattet. Jeweils zwischen den zwei Induktivitäten L befindet sich ein Zwischenanschluss ZW, der potentialmäßig zwischen den in der Figur 1 oberen drei Teilmodulen und den in Figur 1 unteren drei Teilmodulen liegt und einen der drei Wechselspannungsanschlüsse W10 des Multilevelumrichters 30 bildet. Durch die Zwischenanschlüsse ZW werden die drei Reihenschaltungen RES1, RES2 und RES3 jeweils in zwei Untereinheiten unterteilt, die jeweils eine Mehrzahl an in Reihe geschalteten Teilmodulen TM und eine Induktivität L aufweisen und somit jeweils für sich eine Teilmodulreihenschaltung UE bilden, die mindestens zwei in Reihe geschaltete Teilmodule und eine Induktivität umfasst.

Ausführungsbeispiele für bevorzugte Ausgestaltungen der Teilmodule TM wurden oben im Zusammenhang mit den Figuren 1 bis 6 näher erläutert. Diesbezüglich sei auf die obigen Ausführungen verwiesen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 10: Anordnung
- 21: Steuereinrichtung
- 21a: Steuereinrichtung
- 22: Zündeinrichtung
- 22a: Zündeinrichtung
- 30: Multilevelumrichter

- A: Anodenanschluss
- BPS: Bypassschalteinrichtung
- C: Kondensator
- D1: Freilaufdiode
- D2: Freilaufdiode
- G10: Gleichspannungsseite
- G10a: Gleichspannungsanschluss
- G10b: Gleichspannungsanschluss
- K: Kathodenanschluss
- L: Induktivität
- RS: Reihenschaltung
- R1: Widerstand
- R2: Widerstand
- R11: Anschluss
- R12: Anschluss
- R21: Anschluss
- R22: Anschluss
- R31: Anschluss
- R32: Anschluss
- RES1: Reihenschaltung
- RES2: Reihenschaltung
- RES3: Reihenschaltung
- Sa: Bypassaktivierungssignal
- S1: Schalter
- S2: Schalter
- SE1: Schaltelement
- SE2: Schaltelement
- TM: Teilmodul
- TM1: erster Anschluss
- TM2: zweiter Anschluss
- T1: Thyristor
- T2: Thyristor
- UE: Teilmodulreihenschaltung
- Z: Zündanschluss
- Zs: Zündsignal
- ZW: Zwischenanschluss

## Patentansprüche

1. Elektrische Anordnung (10) mit zumindest einem Teilmodul (TM), das einen ersten und einen zweiten äußeren elektrischen Anschluss (TM1, TM2) aufweist,
**dadurch gekennzeichnet, dass**
die Anordnung (10) zumindest eine Bypassschalteinrichtung (BPS) aufweist, die elektrisch zwischen den ersten und zweiten Anschluss (TM1, TM2) des Teilmoduls (TM) geschaltet ist und im eingeschalteten Zustand einen elektrischen Kurzschluss in zumindest einer Stromflussrichtung zwischen den beiden äußeren Anschlüssen (TM1, TM2) des Teilmoduls (TM) hervorruft, wobei die Bypassschalteinrichtung (BPS) aufweist:
- einen Thyristor (T1, T2), der einen Anodenanschluss (A), einen Kathodenanschluss (K) und einen Zündanschluss (Z) aufweist, mit seinem Anodenanschluss (A) an einen der beiden äußeren Anschlüsse (TM1, TM2) des Teilmoduls (TM) angeschlossen ist und mit seinem Kathodenanschluss (K) an den anderen der beiden äußeren Anschlüsse (TM1, TM2) des Teilmoduls (TM) angeschlossen ist,
- eine an den Zündanschluss (Z) des Thyristors (T1, T2) angeschlossene Zündeinrichtung (22, 22a) zum Zünden des Thyristors (T1, T2) und
- einen Schalter (S1, S2), der im eingeschalteten Zustand den Anodenanschluss (A) des Thyristors (T1, T2) mit dem Zündanschluss (Z) des Thyristors (T1, T2) verbindet.

2. Elektrische Anordnung (10) nach Anspruch 1,
**dadurch gekennzeichnet, dass**
die elektrische Anordnung (10) eine Steuereinrichtung (21, 21a) aufweist, die beim Vorliegen eines Bypassaktivierungssignals (Sa) die Zündeinrichtung (22, 22a) mit einem Zündsignal (Zs) aktiviert und den Schalter (S1, S2) schließt.

3. Elektrische Anordnung (10) nach Anspruch 2,
**dadurch gekennzeichnet, dass**
die Steuereinrichtung (21, 21a) derart ausgestaltet ist, dass sie das Zündsignal (Zs) zum Aktivieren der Zündeinrichtung (22, 22a) und zum Zünden des Thyristors (T1, T2) mindestens solange an den Zündanschluss (Z) anlegt, bis der Schalter (S1, S2) seinen eingeschalteten Zustand erreicht hat.

4. Elektrische Anordnung (10) nach einem der voranstehenden Ansprüche,
**dadurch gekennzeichnet, dass**
die Zündeinrichtung (22, 22a) elektrisch zwischen den Zündanschluss (Z) und den Kathodenanschluss (K) des Thyristors (T1, T2) geschaltet ist.

5. Elektrische Anordnung (10) nach einem der voranstehenden Ansprüche,
**dadurch gekennzeichnet, dass**
das Teilmodul (TM) zwischen dem ersten und dem zweiten Anschluss (TM1, TM2) ein Schaltelement (SE1), insbesondere einen Transistor, und eine dazu parallel geschaltete Freilaufdiode (D1) aufweist, deren Kathodenanschluss (K) an den ersten Anschluss (TM1) des Teilmoduls (TM) und deren Anodenanschluss (A) an den zweiten Anschluss (TM2) des Teilmoduls (TM) angeschlossen ist.

6. Elektrische Anordnung (10) nach einem der voranstehenden Ansprüche,
**dadurch gekennzeichnet, dass**
- der Anodenanschluss (A) des Thyristors (T1) an den ersten Anschluss (TM1) des Teilmoduls (TM) angeschlossen ist,
- der Kathodenanschluss (K) des Thyristors (T1) an den zweiten Anschluss (TM2) des Teilmoduls (TM) angeschlossen ist,
- der Schalter (S1) im eingeschalteten Zustand den Anodenanschluss (A) des Thyristors (T1) und damit den ersten Anschluss (TM1) des Teilmoduls (TM) mit dem Zündanschluss (Z) des Thyristors (T1) verbindet und
- die Zündeinrichtung (22) elektrisch zwischen den Zündanschluss (Z) des Thyristors (T1) und den zweiten Anschluss (TM2) des Teilmoduls (TM) geschaltet ist.

7. Elektrische Anordnung (10) nach Anspruch 6,
**dadurch gekennzeichnet, dass**
- die Bypassschalteinrichtung (BPS) zusätzlich zu dem erwähnten Thyristor, nachfolgend erster Thyristor (T1) genannt, einen weiteren Thyristor, nachfolgend zweiter Thyristor (T2) genannt, sowie zusätzlich zu dem erwähnten Schalter, nachfolgend erster Schalter (S1) genannt, einen weiteren Schalter, nachfolgend zweiter Schalter (S2) genannt, aufweist,
- der zweite Thyristor (T2) mit seinem Anodenanschluss (A) an den zweiten Anschluss (TM2) des Teilmoduls (TM) und mit seinem Kathodenanschluss (K) an den ersten Anschluss (TM1) des Teilmoduls (TM) angeschlossen ist, und
- der zweite Schalter (S2) im eingeschalteten Zustand den Anodenanschluss (A) des zweiten Thyristors (T2) und damit den zweiten Anschluss (TM2) des Teilmoduls (TM) mit dem Zündanschluss (Z) des zweiten Thyristors (T2) verbindet.

8. Elektrische Anordnung (10) nach Anspruch 7,
**dadurch gekennzeichnet, dass**
- die Bypassschalteinrichtung (BPS) zusätzlich zu der erwähnten Zündeinrichtung, nachfolgend erste Zündeinrichtung (22) genannt, eine weitere Zündeinrichtung, nachfolgend zweite Zündeinrichtung (22a) genannt, aufweist,
- die erste Zündeinrichtung (22) elektrisch zwischen den Zündanschluss (Z) des ersten Thyristors (T1) und den zweiten Anschluss (TM2) des Teilmoduls (TM) geschaltet ist und
- die zweite Zündeinrichtung (22a) elektrisch zwischen den Zündanschluss (Z) des zweiten Thyristors (T2) und den ersten Anschluss (TM1) des Teilmoduls (TM) geschaltet ist.

9. Elektrische Anordnung (10) nach einem der voranstehenden Ansprüche,
**dadurch gekennzeichnet, dass**
das Teilmodul (TM) ein Halbbrückenmodul oder ein Vollbrückenmodul ist oder durch eine Reihenschaltung aus Halbbrückenmodulen und/oder Vollbrückenmodulen gebildet ist.

10. Elektrische Anordnung (10) nach einem der voranstehenden Ansprüche,
**dadurch gekennzeichnet, dass**
die Anordnung (10) zwei oder mehr Teilmodule (TM) aufweist, die unter Bildung einer Teilmodulreihenschaltung elektrisch in Reihe geschaltet sind und jeweils einen ersten und zweiten äußeren elektrischen Anschluss umfassen, wobei die elektrisch innenliegenden Teilmodule (TM) der Teilmodulreihenschaltung mit ihrem ersten Anschluss (TM1) an einen zweiten Anschluss (TM2) eines potentialmäßig höher liegenden Teilmoduls (TM) der Teilmodulreihenschaltung und mit ihrem zweiten Anschluss (TM2) an einen ersten Anschluss (TM1) eines potentialmäßig tiefer liegenden Teilmoduls (TM) der Teilmodulreihenschaltung angeschlossen sind.

11. Elektrische Anordnung (10) nach einem der voranstehenden Ansprüche,
**dadurch gekennzeichnet, dass**
jedes Teilmodul (TM) jeweils mit einer eigenen Bypassschalteinrichtung (BPS) versehen ist.

12. Elektrische Anordnung (10) nach einem der voranstehenden Ansprüche,
**dadurch gekennzeichnet, dass**
die elektrische Anordnung (10) einen modularen Multilevelumrichter (30) mit zumindest einer Teilmodulreihenschaltung bildet, die mindestens zwei in Reihe geschaltete Teilmodule (TM) und eine Induktivität (L) umfasst.

13. Teilmodul (TM) mit einem ersten und einem zweiten äußeren elektrischen Anschluss für eine elektrische Anordnung (10), insbesondere für eine Anordnung (10) nach einem der voranstehenden Ansprüche, einen Umrichter oder einen Multilevelumrichter (30),
**dadurch gekennzeichnet, dass**
das Teilmodul (TM) zumindest eine Bypassschalteinrichtung (BPS) aufweist, die elektrisch zwischen den ersten und zweiten Anschluss (TM1, TM2) des Teilmoduls (TM) geschaltet ist und im eingeschalteten Zustand einen elektrischen Kurzschluss zwischen den beiden äußeren Anschlüssen des Teilmoduls (TM) hervorruft, wobei die Bypassschalteinrichtung (BPS) aufweist:
- einen Thyristor (T1, T2), der einen Anodenanschluss (A), einen Kathodenanschluss (K) und einen Zündanschluss (Z) aufweist, mit seinem Anodenanschluss (A) an einen der beiden äußeren Anschlüsse des Teilmoduls (TM) angeschlossen ist und mit seinem Kathodenanschluss (K) an den anderen der beiden äußeren Anschlüsse des Teilmoduls (TM) angeschlossen ist,
- eine an den Zündanschluss (Z) des Thyristors (T1, T2) angeschlossene Zündeinrichtung (22, 22a) zum Zünden des Thyristors (T1, T2) und
- einen Schalter (S1, S2), der im eingeschalteten Zustand den Anodenanschluss (A) des Thyristors (T1, T2) mit dem Zündanschluss (Z) des Thyristors (T1, T2) verbindet.

14. Teilmodul (TM) nach Anspruch 13,
**dadurch gekennzeichnet, dass** zwischen den ersten und zweiten Anschluss (TM2) des Teilmoduls (TM) geschaltet sind:
- ein erstes Schaltelement (SE1), insbesondere ein erster Transistor,
- eine zu dem ersten Schaltelement parallel geschaltete Freilaufdiode (D1), deren Kathodenanschluss (K) an den ersten Anschluss (TM1) des Teilmoduls (TM) und deren Anodenanschluss (A) an den zweiten Anschluss (TM2) des Teilmoduls (TM) angeschlossen ist, und
- eine Reihenschaltung (RS) aus einem zweiten Schaltelement, (SE2) zu dem eine zweite Freilaufdiode (D2) parallel geschaltet ist, und ein Energiespeicher, insbesondere Kondensator (C).

15. Teilmodul (TM) nach Anspruch 13 oder 14,
**dadurch gekennzeichnet, dass**
- die Bypassschalteinrichtung (BPS) zusätzlich zu dem erwähnten Thyristor, nachfolgend erster Thyristor (T1) genannt, einen weiteren Thyristor, nachfolgend zweiter Thyristor (T2) genannt, zusätzlich zu dem erwähnten Schalter, nachfolgend erster Schalter (S1) genannt, einen weiteren Schalter, nachfolgend zweiter Schalter (S2) genannt, sowie zusätzlich zu der erwähnten Zündeinrichtung, nachfolgend erste Zündeinrichtung (22) genannt, eine weitere Zündeinrichtung, nachfolgend zweite Zündeinrichtung (22a) genannt, aufweist
- der erste Thyristor (T1) mit seinem Anodenanschluss (A) an den ersten Anschluss (TM1) des Teilmoduls (TM) und mit seinem Kathodenanschluss (K) an den zweiten Anschluss (TM2) des Teilmoduls (TM) angeschlossen ist,
- der erste Schalter (S1) im eingeschalteten Zustand den Anodenanschluss (A) des ersten Thyristors (T1) und damit den ersten Anschluss (TM1) des Teilmoduls (TM) mit dem Zündanschluss (Z) des ersten Thyristors (T1) verbindet,
- der zweite Thyristor (T2) mit seinem Anodenanschluss (A) an den zweiten Anschluss (TM2) des Teilmoduls (TM) und mit seinem Kathodenanschluss (K) an den ersten Anschluss (TM1) des Teilmoduls (TM) angeschlossen ist,
- der zweite Schalter (S2) im eingeschalteten Zustand den Anodenanschluss (A) des zweiten Thyristors (T2) und damit den zweiten Anschluss (TM2) des Teilmoduls (TM) mit dem Zündanschluss (Z) des zweiten Thyristors (T2) verbindet,
- die erste Zündeinrichtung (22) elektrisch zwischen den Zündanschluss (Z) des ersten Thyristors (T1) und den zweiten Anschluss (TM2) des Teilmoduls (TM) geschaltet ist,
- die zweite Zündeinrichtung (22a) elektrisch zwischen den Zündanschluss (Z) des zweiten Thyristors (T2) und den ersten Anschluss (TM1) des Teilmoduls (TM) geschaltet ist,
- die elektrische Anordnung (10) eine oder mehr Steuereinrichtungen (21, 21a) aufweist, die beim Vorliegen eines Bypassaktivierungssignals (Sa) die erste und zweite Zündeinrichtung (22, 22a) mit einem Zündsignal (Zs) aktivieren und den ersten und zweiten Schalter (S1, S2) schließen und
- die Steuereinrichtung (21) oder die Steuereinrichtungen (21, 21a) derart ausgestaltet sind, dass sie die Zündsignale zum Zünden der Thyristoren mindestens solange an den Zündanschluss (Z) anlegt, bis der erste und zweite Schalter (S1, S2) ihren eingeschalteten Zustand erreicht haben.
